# EUROPEAN PATENT APPLICATION

(11) **EP 1 094 600 A1**
(43) Date of publication of application: **25.04.2001**
(21) Application number: 99120696.2
(22) Date of filing: 19.10.1999
(51) Int. Cl.: H03G 3/30

(54) **Apparatus for amplifying signals**

(71) Applicant: SIEMENS AKTIENGESELLSCHAFT, 80333 München (DE)
(72) Inventor: Madsen, Ulrik Riis, 27310 Oak Ridge North Carolina (US)

(57) **Abstract**

The invention relates to an apparatus for amplifying signals, an amplifier (40) being controlled by a feedback loop. In the feedback loop, a threshold voltage is added to a control voltage in order to compensate for the threshold behaviour of the amplifier (40). The test signal of the amplifier (40) is either transferred to the feedback loop by a directional coupler (6) or by using a current mirror in the last stage of the amplifier (41). For a summing device, which is used for subtracting an output voltage of a power detector (7) from a reference voltage in order to find out the deviation of the amplifier (40) from its optimum operation conditions an operational amplifier or a resistive adder is used. For the adder (12) an operational amplifier is implemented.

## Description

### Prior art

The invention relates to an apparatus for amplifying signals in accordance with the generic class of the independent claim.

In Richard C. Dorf and Robert H. Bishop: "Modern control systems", Addison-Wesley, ISBN 0-201-84559-8, pages 477 to 480, it is already reported that a time delay in a loop causes a phase lag leading to a reduction of stability of the loop. The time delay is the time interval between a start of an event and the resulting action. To cope with the time delay and the resulting instability, the loop gain is reduced.

### Advantages of the invention

The apparatus for amplifying signals having the characterising features of the independent patent claim has the advantage, that the time delay is minimised in order to improve the stability of the loop. Simultaneously, an optimum control of the apparatus for amplifying signals is achieved.

Furthermore, it is an advantage that an integrator response time of the integrator being used in the loop can be long, so that a cheaper integrator can be used.

Apart from this, it is an advantage to add simply a threshold voltage to a control voltage in order to generate a control signal controlling the amplifier. This is a very easy method and leads to a cheap product. Moreover, the value of the threshold voltage is easily adapted to any kind of amplifier, so that the invention is universally useable.

In addition, a steady state error is avoided by implementing an integrator exhibiting an extremely high gain for steady state signals.

The features of the dependent patent claims enable further improvements of the invention.

It is an advantage to use a part of the output power as a measure for the feedback loop. The output power is to be controlled by the feedback loop and, therefore, it is an efficient method to use a part of the output power to generate the control signal.

Furthermore, it is an advantage that as a summing device either an operational amplifier giving efficient results or a resistive adder is used. The resistive adder is very simple to implement.

Apart from this, it is an advantage to use as an adder an operational amplifier which is an easy and cheap solution.

Furthermore, it is an advantage to use a directional coupler which is easy to realise and easy to adapt to different implementations.

Apart from this, a current mirror in the amplifier is used to generate a measure which is used to generate the control signal. A current mirror saves circuit elements and simplifies the circuit structure of the feedback loop.

Moreover, it is an advantage to use a voltage over a resistor being in series with a collector of a last transistor of the amplifier to generate the control signal. This saves circuit elements and simplifies the circuit structure of the feedback loop.

### Drawings

Exemplary embodiments of the invention are shown in the figures and elucidated in detail in the description below. Figure 1 shows a first block diagram of a transmitter, figure 2 shows a directional coupler, figure 3 shows a second block diagram of a transmitter and figure 4 shows a current mirror.

### Description

An amplifier for a transmitter in a mobile phone is controlled by a feedback loop in order to keep a constant output power. This is necessary because variations in an input power, a supply voltage of the amplifier, a temperature of the amplifier and an impedance termination facing an output of the amplifier cause variations in the output power of the amplifier. To compensate for these effects, the amplifier is thereby controlled by a control voltage which itself is generated by measuring an output signal of the amplifier. This is then commonly called automatic gain control (AGC).

In the amplifier, there are transistors entailing a threshold voltage for the control voltage to exceed for putting the amplifier into action, that means the amplifier amplifies signals at its input. This causes a time delay due to the reaction of the amplifier to the control voltage. The time delay, however, leads to an unstable loop.

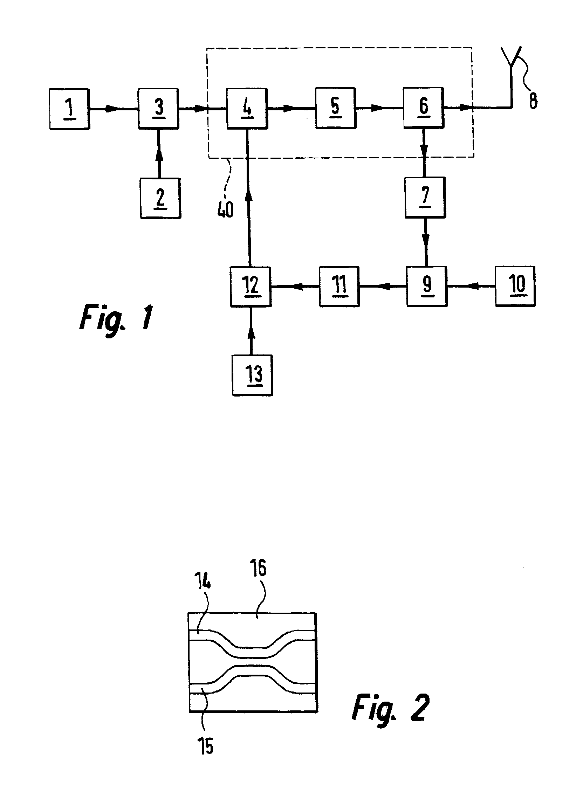

In Fig. 1, a transmitter using the feedback loop after the invention is shown. A data source 1 generates the signals to be transmitted. The data source 1 is a microphone with additional electronics to convert acoustical waves into electrical signals and to amplify and to digitise them, so that a digital data stream is created consisting of ones and zeros as the binary symbols. Apart from this, the data source 1 can be a camera or a computer terminal but it is not limited to these data sources. The following description deals only with speech signals.

The digitised data undergo then speech coding in the data source 1 in order to reduce redundancy from the digitised speech signals and, consequently, to reduce the data size. Speech coding removes that redundancy that is not important for reproducing speech signals in a receiver. Psycho-acoustical models are used to determine which data is redundant and which is not.

For error protection of the data, error detecting and error correcting codes are added after the speech coding, so that using this newly added redundancy, the receiver is able to detect and correct errors in the received signals. The error protected data are then modulated in a modulator 3 after feeding those data in the modulator 3 via its first input. For GSM (Global System for Mobile communication), GMSK (Gaussian Minimum Shift Keying) is the chosen modulation technique.

GMSK is a constant envelope modulation technique using two frequencies. The envelope is constant and therefore independent of time. The error protected data as a bit stream is inspected by the modulator 3 in groups of two successive bits. The sequences 11 and 00 are mapped to a higher of the two frequencies whereas the sequences 01 and 10 lead to the lower of the two frequencies. Thus, certain sequences in the data stream lead to certain frequencies, so that a digital frequency modulation is realised. Since two frequencies are needed, usually one local oscillator 2 is employed for generating one frequency and feeding a signal with this frequency into the modulator 3 via its second input. A frequency doubler or tripler is used for doubling or tripling the frequency of the local oscillator to generate the other frequency. Alternatively, another local oscillator can be added to generate the second frequency or even a tunable oscillator. These devices are connected to the modulator 3 which performs the modulation.

After the mapping of the bit groups to the two frequencies, the created signal with the two frequencies is filtered by a Gaussian filter to smooth the transition from one frequency to the other frequency. In addition, the modulated signals are converted to radio frequencies in order to generate radio frequency signals.

An amplifier 40 comprising an amplifying device 4, a matching network 5 and a directional coupler 6 is used for amplifying those modulated radio frequency signals. An output of the modulator 3 is connected to a first input of the amplifying device 4 and therefore a first input of the amplifier 40. The modulated radio frequency signals are then amplified by the amplifying device 4 according to a control signal being transferred from an adder 12 to a second input of the amplifier 40 which is also the second input of the amplifying device 4. In this way, the control signal determines the amplification of the amplifying device 4 and therefore of the amplifier 4. An output of the amplifying device 4 is connected to the directional coupler 6 by the matching network 5.

The matching network 5 exhibits only passive components and it takes care that an output impedance of the amplifying device 4 is matched to an input impedance of the directional coupler 6, so that no power is reflected from the input of the directional coupler 6 back to the output of the amplifying device 4.

The directional coupler 6 transfers a small amount of the output power to an input of a power detector 7 from its first output. The larger amount (99%) of the output power is transferred via its second output to an antenna 8. The first and second output of the directional coupler 6 are identical to the first and second output of the amplifier 40. The amplified signals are then transmitted by the antenna 8 to the receiver.

Fig. 2 shows schematically a directional coupler. The directional coupler 6 consists of two microstrip lines 14 and 15 being placed on a substrate 16. This configuration enables the electromagnetic coupling between those lines. An appropriate termination of four terminals of the directional coupler 6 determines how much power is transferred from one microstrip line to the other microstrip line. In addition, a distance between the microstrip lines influences a degree of the electromagnetic coupling.

The power detector 7 gives a measure of a transferred power to its input as an output voltage at its output. A diode rectifier is used as the power detector 7.

A summing device 9 subtracts from the output voltage of the power detector 7 a reference voltage which is provided by a conventional voltage regulator 10 in order to generate a difference voltage. For the summing device 9 an operational amplifier is used. Alternatively, a resistive adder can be implemented.

The voltage regulator 10 provides a stable voltage supply for the reference voltage, so that fluctuations in a power supply do not affect the reference voltage.

The difference voltage of the output voltage and the reference voltage is a direct measure of the deviation of the amplifying device 4 from its optimum operation conditions. Is the difference voltage small, then the amplifying device 4 operates also near optimum operation conditions. Is the difference voltage large, then the amplifying device 4 is far off its optimum operation conditions.

The difference voltage is fed in an input of an integrator 11 and then integrated. The integrator 11 is used because an integrator offers a very high gain for steady state signals and thereby minimising a steady state error. The result of the integrator 11 which is a control voltage is added to a threshold voltage which is provided by a voltage regulator 13 in order to generate a control signal for the amplifier 40 and especially the amplifying device 4. This addition is performed by an adder 12. The first input of the adder 12 is connected to the output of the integrator 11, so that the control voltage is at the first input of the adder 12. The threshold voltage is fed into the adder 12 via the second input of the adder 12 from the output of the voltage regulator 13.

This threshold voltage is equal to the threshold voltage of the amplifying device 4. A transistor which is used in an amplifying device exhibits a threshold voltage due to physical reasons. This threshold voltage differs for different types of transistors. Below this threshold voltage the transistor does not operate as an amplifier. Therefore, if the control signal was set only according to the test signal, it would be too low and consequently, the control signal must be increased consuming unnecessarily time. Using the invention renders the feedback control loop of the amplifier faster and more stable.

The threshold voltage is added in order to use the control voltage generated by the integrator 11 for altering the output power of the amplifying device 4, the threshold voltage being used to overcome the threshold of the amplifying device 4. Therefore, the adder 12 is connected to the second input of the amplifying device 4 which is equal to the second input of the amplifier 40 in order to transfer the control signal to the amplifying device 4.

Instead of using a directional coupler to transfer a part of the output power into the feedback loop, it is also possible to use a signal current of a current mirror in the last stage of the amplifying device 4 as a measure of the output power of the amplifying device 4. This measure characterises the output power of the amplifier 40 as well.

A current mirror is a circuit which consists basically of two transistors with matched properties. If both transistors are equal, it is possible to impress a collector current in the first transistor which causes a appropriate base-emitter voltage drop in the first transistor. The second transistor is switched in relation to the first transistor, so that the base-emitter voltage drop is the same at the second transistor. Consequently, the collector current in the second transistor is the same, too.

By switching more transistors in parallel to the second transistor, it is possible to achieve a multiple of the collector current as the resulting current of the second transistor and the transistors switched in parallel to the second transistor. In this way, the current ratio is increased. Another method to increase the current ratio is to adjust the size of the emitter junctions which is the same if you switch transistors in parallel, it is then done in one transistor.

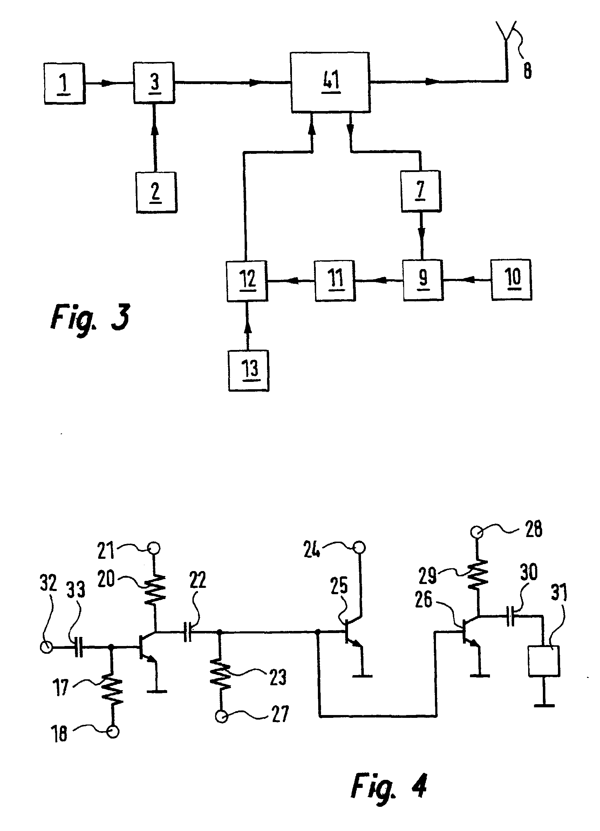

Figure 3 shows a second block diagram of a transmitter with the an amplifier 41 with a feedback loop. The structure of this transmitter is equal to the structure of Fig. 1 except that the configuration of the amplifier 41 differs from the configuration of the amplifier 40. A modulator 3 exhbits two inputs, a first input is connected to an output of a data source 1 and a second input is connected to a local oscillator 2. The modulator 3 generates a radio frequency signal using the data signal from the data source 1 and signal from the local oscillator 2. The radio frequency signal of the modulator 3 is fed into the first input of the amplifier 41.

The amplifier 41 exhibits a second input which is used for the control signal from the adder 12 in order to adjust the amplification of the amplifier 41. A first output of the amplifier 41 is connected to the antenna 8 for transmitting the amplified radio frequency signals. A second output of the amplifier 41 is connected to a detector 7. Over this second output a current of the last stage of the amplifier 41 is fed into the detector 7. This current is a collector current of the last transistor of the amplifier 41. The detector 7 is connected to a first input of the adder 9. The voltage regulator 10 is connected to the second input of the adder 9, so that the adder 9 generates the difference voltage as described above. The output of the adder 9 is connected to the integrator 11. The integrator 11 generates the control voltage which is fed into the first input of the adder 12. A voltage regulator 13 supplies the threshold voltage to the second input of the adder 12. The adder 12 generates the control signal by adding the threshold voltage and the control voltage. The control signal is then supplied to the second input of the amplifier 41.

Figure 4 shows the last two stages of the amplifier 41 using a current mirror. At an input 18 a bias current for a transistor 19 is fed in. This bias current is generated by a current source in the amplifier. The bias current flows through a resistor 17 to a base of the transistor 19. A capacitor 33 which is also connected to the base of the transistor 19 blocks the bias current, since the bias current is a direct current.

At an input 32 a signal to be amplified which consists of an alternate current is fed in. The capacitor 33 is dimensioned, so that this alternate current passes the capacitor 33. The signal is then amplified by the transistor 19. Between an emitter and a collector of the transistor 19 the amplified signal is present. The emitter of the transistor 19 is connected to mass. A capacitor 22 connects the collector of the transistor 19 to a base of a transistor 25. A resistor 20 connects the collector of the transistor 19 to a voltage supply 21.

The amplified signal passes the capacitor 22 to be connected to the base of the transistor 25. A resistor 23 is connected to the base of the transistor 25. On the other side of the resistor 23 an input is placed which is used for feeding in a bias current for the transistor 25. This bias current is also generated by a current source in the amplifier. The base of the transistor 25 is also connected to a base of a transistor 26, so that the signal is also present at the base of the transistor 26 to be amplified. A current which is impressed at an input 24 being connected to a collector of the transistor 25 determines the base-emitter voltage of the transistor 25. Since an emitter of the transistor 25 and an emitter of the transistor 26 are connected both to mass and since their bases are connected together, the base-emitter voltage of the transistor 25 is equal to the base-emitter voltage of the transistor 26. In this way, the collector current of the transistor 25 determines the base-emitter voltage of the transistor 26 and thereby a gain and a collector current of the transistor 26. This is called current mirror. By an appropriate design of the transistors 25 and 26 a ratio between the collector currents of those transistors is fixed. It is advantage to use a current mirror because it is easy to generate a collector current in a device.

The collector of the transistor 26 is connected to a resistor 29 connecting the collector to a supply voltage and to a capacitor 30 which is again used for passing the amplified signal over and blocking the bias currents of the transistor 26. On the other side of the capacitor 30 an impedance 31 is connected which itself is connected to mass. The impedance 31 represents a current divider where the larger part of the current is used for transmission of the signal and the minor part for determining the signal power for adjusting the amplification of the amplifier. For this adjustment, the bias currents and the collector current of the transistor 26 are changed.

Alternatively, a voltage over the resistor 28 which is in series with a collector of the transistor 26 is a direct measure of the output power of the amplifier, since power is a product of current and voltage. Thus, this voltage can directly be compared with the reference voltage in order to generate the difference voltage leading to the control signal.

The invention is useful for all feedback loops exhibiting a delay due to a threshold in an amplifier.

## Claims

1. Apparatus for amplifying signals, comprising: an amplifier (40, 41) exhibiting a first input for signals to be amplified, a second input for a control signal determining an amplification of the amplifier (40, 41), a first output for amplified signals and a second output for a test signal characterising a power of the amplified signals, a detector converting the test signal to an output voltage, a summing device (9) subtracting the output voltage from a reference voltage to generate a difference voltage, an integrator (11) integrating the difference voltage to generate a control voltage, characterised in that an adder (12) adds a threshold voltage to the control voltage in order to generate the control signal controlling the amplifier (40, 41).

2. Apparatus according to claim 1, wherein the amplifier comprises a coupler (6), a matching network (5) and a amplifiying device (4), the coupler (6) transfers a first part of an output power of the amplifying device (4) to a transmitting device and a second part of the output power of the amplifying device (4) as the test signal to a power detector (7) as the said detector.

3. Apparatus according to claim 1, wherein the summing device (9) is an operational amplifier or a resistive adder.

4. Apparatus according to claim 1, wherein the adder (12) is an operational amplifier.

5. Apparatus according to claim 1, wherein the coupler (6) is a directional coupler.

6. Apparatus according to claim 1, wherein a current from a current mirror being employed in the last stage of the amplifier (41) is used as the test signal and a resistor as the detector converts the said current to the output voltage.

7. Apparatus according to claim 1 wherein a voltage at a resistor (29) being in series with a collector of a last transistor (26) of the amplifier (41) is used as the test signal.
